(19) Europäisches Patentamt
European Patent Office
Office européen des brevets

(11) **EP 2 448 112 A1**

(12) **EUROPEAN PATENT APPLICATION**

(43) Date of publication:
**02.05.2012 Bulletin 2012/18**

(51) Int Cl.:
*H03F 1/32* (2006.01)      *H03F 3/189* (2006.01)
*H03F 3/24* (2006.01)

(21) Application number: **10290588.2**

(22) Date of filing: **29.10.2010**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**75007 Paris (FR)**

(72) Inventors:
• **Xin, Yu**
**70435 Stuttgart (DE)**

• **Bohn, Thomas**
**70372 Stuttgart (DE)**
• **Haslach, Christoph, Dr.**
**70178 Stuttgart (DE)**

(74) Representative: **Dreiss**
**Patentanwälte**
**Postfach 10 37 62**
**70032 Stuttgart (DE)**

(54) **Digital predistortion device and method of operating a digital predistortion device**

(57) The invention relates to a digital predistortion device (100) for applying a predistortion to a signal that is to be processed by a power amplifier (200), wherein said digital predistortion device (100) comprises at least two predistortion branches (111, 112), wherein each of said predistortion branches (111, 112) is configured to apply a predistortion to an input signal (S1, S2) of said predistortion branch (111, 112) according to a predistortion function (f_DPD1, f_DPD2) associated with said predistortion branch (111, 112), wherein a predistortion function (f_DPD1, f_DPD2) of at least one of said predistortion branches (111, 112) depends on the input signals (S1, S2) of at least two of said predistortion branches (111, 112).

## Fig. 1

EP 2 448 112 A1

**Description**

FIELD OF THE INVENTION

The invention relates to a digital predistortion device for applying a predistortion to a signal that is to be processed by a power amplifier.

The invention further relates to a method of operating a digital predistortion device of the aforementioned type.

BACKGROUND

While processing signals, power amplifiers and other active components usually introduce nonlinearities to the processed signal. To mitigate this undesired effect, it is known to apply a predistortion to the signal prior to processing by the power amplifier, wherein said predistortion aims at compensating the nonlinearities introduced by the further processing by means of the power amplifier.

It is an object of the present invention to provide an improved digital predistortion device and an improved method of operating a digital predistortion device which enable an increased degree of flexibility regarding signal processing, especially in the case of simultaneously processing input signals of various target frequencies.

SUMMARY

According to the present invention, regarding the above mentioned digital predistortion device, this object is achieved in that said digital predistortion device comprises at least two predistortion branches, wherein each of said predistortion branches is configured to apply a predistortion to an input signal of said predistortion branch according to a predistortion function associated with said predistortion branch, wherein a predistortion function of at least one of said predistortion branches depends on the input signals of at least two of said predistortion branches.

The proposed predistortion device advantageously enables to simultaneously process two or more input signals by means of the plurality of predistortion branches, wherein each input signal is preferably handled by a dedicated predistortion branch. Further advantageously, the process of predistortion as such depends on the input signals of at least two of said predistortion branches, rather than only considering a specific input signal to be predistorted by a specific predistortion branch. Taking into account multiple input signals for applying a predistortion to a specific one of said input signals advantageously enables to efficiently compensate nonlinearities that are introduced by a power amplifier which simultaneously processes various output signals provided by the digital predistortion device depending on said input signals. I.e., in the case that two input signals are to be predistorted by the digital predistortion device according to the embodiments, two predistorted corresponding output signals are obtained. If both output signals are to be processed by the same power amplifier, the nonlinearities added to said output signals comprise a correlation with each other. This effect is advantageously taken into consideration by the digital predistortion device by means of applying a predistortion function which depends on at least two of said input signals for the digital predistortion device.

According to a particularly advantageous embodiment, a predistortion function of at least one of said predistortion branches depends on the input signals of all of the predistortion branches, which is a preferred variant in such cases where a power amplifier, especially simultaneously, processes all output signals obtained by the digital predistortion device.

According to a further embodiment, a predistortion function of at least one of said predistortion branches depends on a sum of absolute values of said input signals. According to applicant's analysis, this embodiment yields a particularly precise compensation of nonlinearities.

According to a further embodiment, said digital predistortion device comprises means for evaluating a sum of absolute values of all input signals processed by the digital predistortion device.

According to a further advantageous embodiment, said digital predistortion device comprises at least one crosstalk mitigation branch that is configured to modify an output of a first predistortion branch, which is associated with a first input signal, depending on said first input signal and at least one further input signal processed by said digital predistortion device, which accounts for possible crosstalk effects that may also arise when simultaneously processing several output signals of the digital predistortion device by a common power amplifier or a common further signal processing unit.

According to a further embodiment, said digital predistortion device comprises a digital predistortion learning section that is configured to receive at least one of: said input signals, output signals of a predistortion branch, feedback signals depending on said output signals, wherein said predistortion learning section is further configured to modify at least one predistortion function associated with at least one predistortion branch. Thus, the predistortion process provided for by the predistortion device may continuously be improved by means of a closed-loop control.

According to a further advantageous embodiment, the predistortion learning section may also be configured to modify parameters of at least one cross talk mitigation branch, whereby crosstalk mitigation may be improved.

A further solution to the object of the present invention is given by an amplifier system according to claim 7. The amplifier system comprises at least one digital predistortion device according to the embodiments, signal processing means that are configured to transform a plurality of output signals of said digital predistortion device to a predistorted radio frequency, RF, signal, and a power amplifier for amplifying said predistorted RF signal.

According to an embodiment of said amplifier system, said signal processing means comprise at least two upconversion paths, each of said upconversion paths being configured to transform an output signal of said digital predistortion device to a target frequency range associated with a respective center frequency within said predistorted RF signal.

In 3GPP (Third Generation Partnership Project) standardization, a technique also denoted as "fragmented carrier aggregation" is in discussion, which is inter alia pushed by the operators of communications networks. The field of "fragmented carrier aggregation" requires transmitter equipment to be able to simultaneously transmit multiple different signals (e.g. LTE and GSM signals), even in different frequency bands. Transmitters supporting such features must be able to send signals located in different frequency bands with a single power amplifier (PA) in order to avoid extra costs for multiple (band-specific) power amplifiers. The frequency spacing between the single fragmented frequency bands varies from dozens of MHz up to the GHz-range.

One of the key elements to improve transmitter efficiency is the approach of digital predistortion, which is performed in the digital domain. From the view of the digital signal processing, the fact that signals are located in fragmented frequency bands with frequency gaps up to the GHz range results in expanded signal bandwidths. This cannot be handled in the latest FPGA Technology because of the extreme high bandwidth of the aggregated signals.

However, the digital predistortion structures according to the embodiments advantageously enable to apply numerous highly efficient power amplifier concepts known from single band transmission to the simultaneous coverage of fragmented frequency bands.

As such, for example, two input signals may be applied to the digital predistortion device according to the embodiments, wherein each of said input signals is processed by the predistortion device by means of a respective predistortion branch, whereby two predistorted output signals are obtained.

Said output signals may be upconverted by per se known steps of signal processing and by using corresponding components, i.e. by converting said predistorted output signals from the digital domain to an analog domain by means of a digital to analog converter. A so obtained analog signal may be modulated, i.e. by multiplying it with a local oscillator signal, whereby an upconverted signal is obtained. Such processing may also be applied to the second output signal of the digital predistortion device. The respective local oscillator frequencies may e.g. be chosen according to the requirements of the target system. I.e., if the concept of the fragmented frequency bands is to be applied, the first upconverted output signal may e.g. be situated in a first frequency range, for example around 2.1 GHz. Likewise, the second upconverted output signal may be situated in a second target frequency range of about 2.6 GHz. Said upconverted output signals may be added and fed to a common power amplifier which amplifies the so obtained sum signal. I.e., both upconverted output signals are simultaneously processed by a single power amplifier, which, in a per se known manner, introduces nonlinearities, i.e. distortions, to the signal to be amplified.

A portion of the amplified predistorted signal may be fed back to the digital predistortion device according to the embodiments by a per se known feedback path mechanism so as to enable the digital predistortion device to dynamically adapt its predistortion strategy / predistortion coefficients in order to apply a proper predistortion to the input signals to be processed.

Since both input signals in their upconverted form have been processed simultaneously by the common power amplifier, the nonlinearities are related to both input signals. Thus, advantageously, the predistortion strategy employed by the digital predistortion device according to the embodiments enables to consider both input signals when applying a predistortion to one or two of said input signals, whereby a particularly efficient predistortion is effected.

According to a further particularly preferred embodiment, both input signals are each processed in the sense of digital predistortion depending on the input signals fed to the digital predistortion device.

A further solution to the object of the present invention is given by a method of operating a digital predistortion device according to claim 9. Said method proposes to apply a predistortion to a signal that is to be processed by a power amplifier, wherein said digital predistortion device comprises at least two predistortion branches, wherein each of said predistortion branches applies a predistortion to an input signal of said predistortion branch according to a predistortion function associated with said predistortion branch, wherein a predistortion function of at least one of said predistortion branches depends on the input signals of at least two of said predistortion branches.

A further solution to the object of the present invention is given by a method of operating an amplifier system according to claim 13.

Further advantageous embodiments are defined by the dependent claims.

Further aspects, features and advantages of the present invention are given in the following detailed description with reference to the drawings in which:

Fig. 1    depicts a simplified block diagram of a digital predistortion device according to an embodiment,

Fig. 2    depicts frequency components of an RF signal as obtained according to a further embodiment,

Fig. 3    depicts a block diagram of an amplifier system comprising a digital predistortion device according to a further embodiment,

Fig. 4    depicts a portion of the digital predistortion device of Fig. 3,

Fig. 5    depicts a simplified block diagram of a predistortion branch of a digital predistortion device according to an embodiment,

Fig. 6    depicts a further embodiment of a digital predistortion device,

Fig. 7    depicts a simplified block diagram of a crosstalk mitigation branch of the arrangement according to Fig. 6, and

Fig. 8    depicts a simplified flow chart of a method according to the embodiments.

DESCRIPTION OF THE EMBODIMENTS

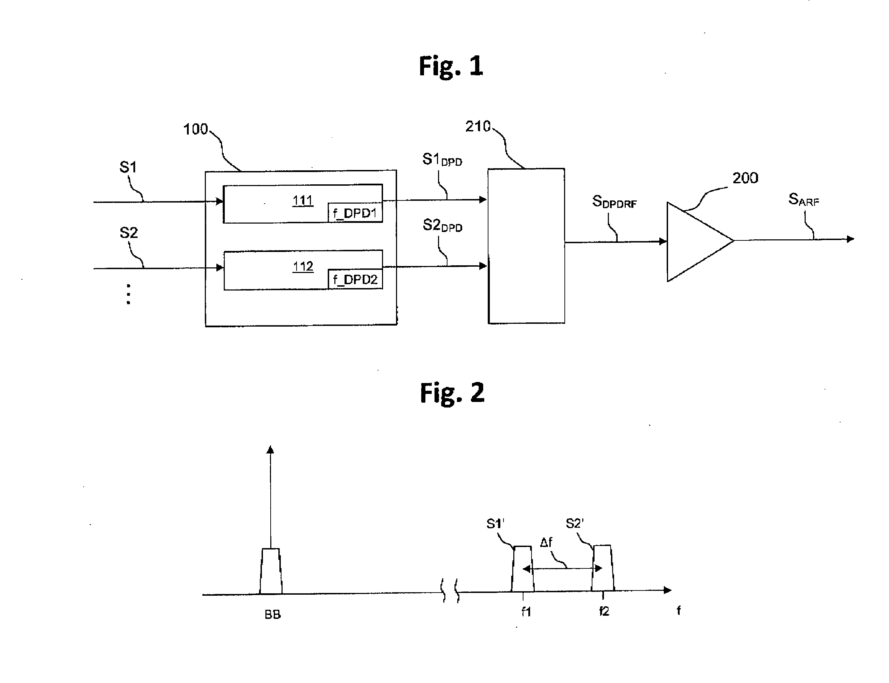

Fig. 1 depicts a simplified block diagram of a digital predistortion device 100 according to a first embodiment. The digital predistortion device 100 receives a plurality of input signals S1, S2, ... which may, according to a preferred embodiment, be digital baseband signals that e.g. correspond to one or more user data streams which are processed by a base station of a cellular communications network.

The digital predistortion device 100 applies a digital predistortion to each of the input signals S1, S2, ..., whereby digitally predistorted output signals $S1_{DPD}$, $S2_{DPD}$ are obtained at an output of said digital predistortion device 100.

The digitally predistorted output signals $S1_{DPD}$, $S2_{DPD}$ are forwarded to signal processing means 210 that are configured to transform said output signals $SL_{DPD}$, $S2_{DPD}$ to a predistorted radio frequency RF, signal $S_{DPDRF}$. The predistorted RF signal $S_{DPDRF}$ is finally amplified by a power amplifier 200, whereby an amplified RF signal $S_{ARF}$ is obtained.

Advantageously, the predistortion applied to the input signals S1, S2, ... by the digital predistortion device 100 compensates any nonlinearities, i.e. distortions, introduced to the digitally predistorted RF signal $S_{DPDRF}$ by the power amplifier 200.

Thus, the amplified RF signal $S_{ARF}$ comprises less nonlinearities as compared to an amplified RF signal the frequency components of which have not been predistorted prior to amplification.

Fig. 2 depicts frequency components of the digitally predistorted RF signal $S_{DPDRF}$ as obtained via processing by the signal processing means 210.

While the input signals S1, S2, .. supplied to the digital predistortion device 100 (Fig. 1) usually are digital baseband signals, cf. the baseband frequency range BB of Fig. 2, the predistorted output signals $S1_{DPD}$. $S2_{DPD}$ are transformed to a certain predetermined target frequency range, for example by modulation. For instance, the first digitally predistorted output signal $S1_{DPD}$, which still is a digital baseband signal, is multiplied by a local oscillator signal comprising a frequency f1, whereby the output signal $S1_{DPD}$ is shifted to the target frequency range f1. I.e., the signal component S1' of Fig. 2 represents the upconverted output signal $S1_{DPD}$. Usually, prior to upconversion, the digitally predistorted output signal $S1_{DPD}$, which is a digital signal, is converted to an analog domain by a digital to analog conversion not depicted by Fig. 1.

In analogy to the aforementioned signal processing of the output signal $S1_{DPD}$, the second predistorted output signal $S2_{DPD}$ is upconverted, i.e. transferred to a second target frequency range f2, cf. the reference numeral S2' of Fig. 2.

A frequency spacing $\Delta f$ between the upconverted signals s1', S2' depends on the respective center frequencies f1, f2 that have been used in the course of the upconversion process by the signal processing means 210 (Fig. 1).

When applying the concept of the fragmented frequency bands, comparatively large frequency spacings $\Delta f$ of about tens of MHz to even tens of GHz may occur, depending of the target frequencies of each input signal.

In view of these requirements, the signal processing provided by the digital predistortion device 100 according to the embodiments is particularly advantageous in that it enables to process the involved signals, i.e. the input signals S1, S2, in baseband thus not requiring unnecessarily high bandwidths of the involved components.

The digital predistortion device 100 according to the embodiment depicted by Fig. 1 comprises one predistortion branch 111, 112 for each input signal S1, S2 to be predistorted. Each of said predistortion branches 111, 112 is configured to apply a predistortion to its input signal S1, S2 according to a predistortion function f_DPD1, f_DPD2 that is associated with the respective predistortion branch 111, 112.

Thus, an individual digital predistortion of the respective input signals S1, S2 is enabled.

Advantageously, the predistortion function f_DPD1, f_DPD2 of at least one of said predistortion branches 111, 112 depends on the input signals S1, S2 of at least two of said predistortion branches 111, 112. This principle advantageously accounts for the common and simultaneous signal processing of the output signals $S1_{DPD}$, $S2_{DPD}$ by the components 210, 200. By not only considering a respective input signal S1 fed to a respective predistortion branch 111, a particularly precise and efficient digital predistortion of the input signals S1, S2 may be achieved.

According to an advantageous embodiment, a predistortion function f_DPD1, f_DPD2 of at least one of said predistortion branches 111, 112 depends on the input signals S1, S2 of all of said predistortion branches 111, 112, whereby a comprehensive digital predistortion may be performed that takes into account the influences of any input signals that are later on commonly processed by the components 200, 210.

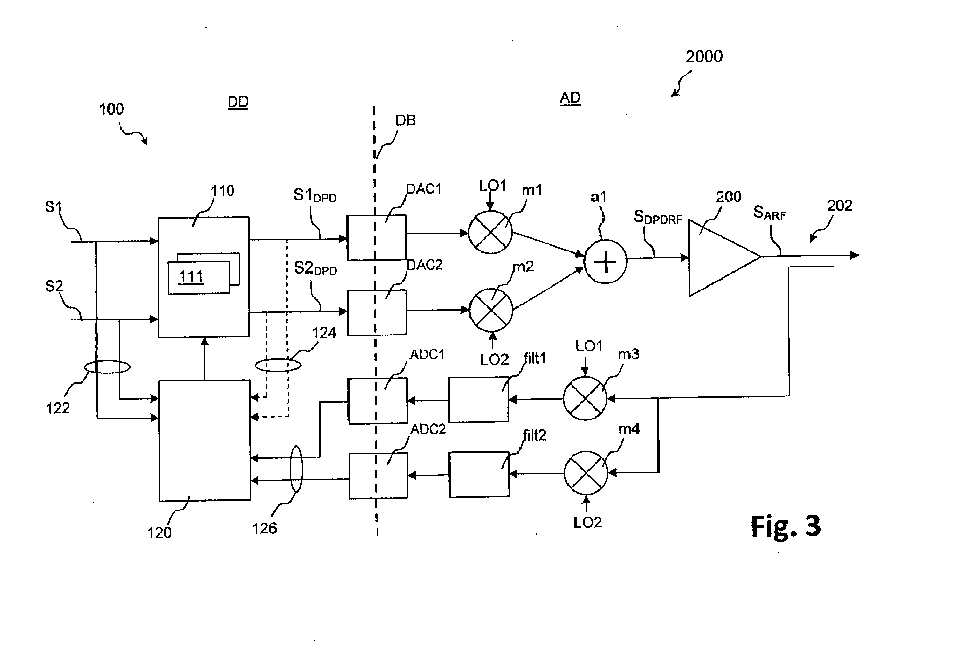

Fig. 3 depicts an exemplary block diagram of an amplifier system 2000. The amplifier system 2000 comprises a digital predistortion device 100, which is operating in a digital domain DD. A border to an analog domain AD is symbolized by the dashed line DB in Figure 3. The digital predistortion device 100 receives input signals S1, S2, which again may be digital baseband signals, and which have to be digitally predistorted in order to account for any nonlinearities introduced by a later amplification by means of the power amplifier 200. Thus, the input signals S1, S2 are predistorted by a predistortion processing portion 110 of the digital predistortion device 100. At an output of the predistortion processing portion 110, the digitally predistorted output signals $S1_{DPD}$, $S2_{DPD}$ are obtained. The digitally predistorted output signals $S1_{DPD}$, $S2_{DPD}$ are converted to the analog domain AD by means of a respective digital to analog converter DAC1, DAC2, whereby analog predistorted signals are obtained.

Each analog predistorted signal is supplied to a respective multiplier m1, m2, which performs a multiplication of the respective input signal with a local oscillator signal LO1, LO2. The local oscillator signals LO1, LO2 may e.g. be related to the target frequencies f1, f2 as depicted by Fig. 2.

At an output of the multipliers m1, m2, respective upconverted signal portions S1', S2' are obtained, which are added by the adder a1, whereby a digitally predistorted RF signal $S_{DPDRF}$, which comprises at least the frequency components S1', S2' according to Fig. 2, is obtained. The digitally predistorted RF signal $S_{DPDRF}$ is amplified by the power amplifier 200, whereby an amplified RF signal $S_{ARF}$ is obtained at an output of said power amplifier 200. The amplified RF signal may e.g. be fed to an antenna system for transmission to one or more receivers such as terminals of a cellular communications system or the like.

A coupling structure 202 couples a portion of the amplified RF signal $S_{ARF}$ to further multipliers m3, m4, which are also supplied with the local oscillator signals LO1, LO2 for downconverting (i.e. transforming to a lower frequency range such as e.g. a baseband range BB) the respective frequency portions S1', S2' (Fig. 2) of the amplified RF signal $S_{ARF}$. The downconverted signal portions are converted from the analog domain AD back to the digital domain DD by respective analog to digital converters ADC1, ADC2.

Prior to converting the downconverted analog signals to the digital domain DD by means of the converters ADC1, ADC2, a respective filtering process may be performed by means of the filtering blocks filt1, filt2.

The components m3, filt1, ADC1 and m4, filt2, ADC2 as such constitute feedback paths which provide a downconverted digital signal depending on the respective input signal S1, S2 in the sense of feedback signals 126 to the digital predistortion device 100.

The feedback signals 126 inter alia comprise information on the nonlinearities imparted on the amplified signal $S_{ARF}$ by the amplifier 200. Said information may advantageously be employed by the digital predistortion device 100 to perform and/or optimize the predistortion coefficients applied to the input signals S1, S2.

The feedback signals 126 are received by a predistortion learning section 120 of the digital predistortion device 100, which may also receive the input signals 122 and, optionally also, the digitally predistorted output signals 124 for an alternative process of predistortion learning.

The results of the predistortion learning are forwarded by the predistortion learning section 120 to the predistortion processing portion 110 that comprises the predistortion branches 111, 112 as already explained above. The results of the predistortion learning may e.g. be used to modify the predistortion functions f_DPD1, f_DPD2 (Fig. 1) to ensure a proper predistortion.

According to a particularly preferred embodiment, the predistortion functions f_DPD1, f_DPD2 (Fig. 1) as implemented in the respective predistortion branches 111, 112 of the predistortion processing section 110 depend on a sum $S_{BS}$ of absolute values of said input signals S1, S2, which yields a particularly efficient predistortion:

```
S_BS = abs(S1) + abs(S2), wherein abs(x) denotes an absolute
value of x.
```

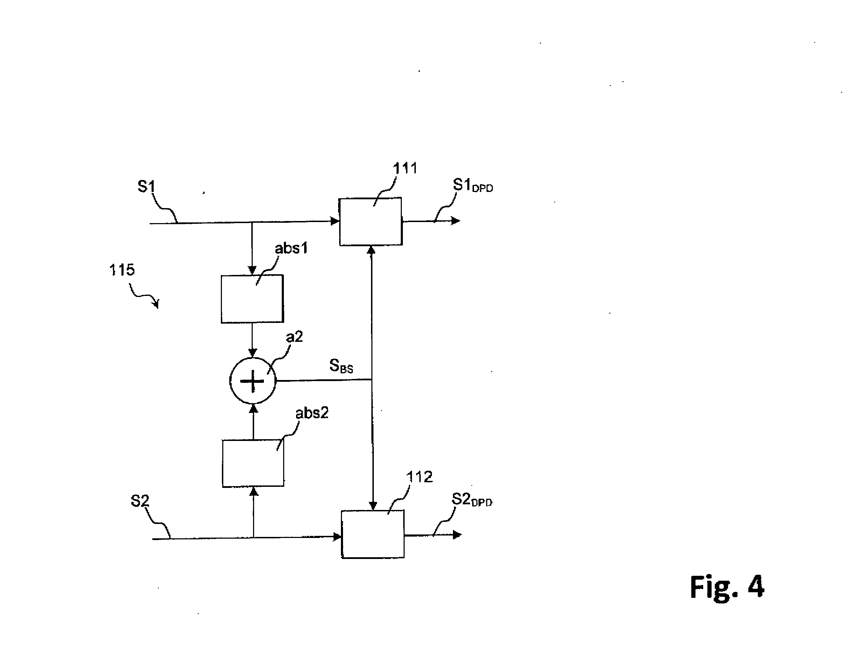

Fig. 4 depicts means 115 for evaluating said sum $S_{BS}$ of absolute values of all input signals S1, S2 processed by the digital predistortion device 100.

For this purpose, a function block abs1 receives the first input signal S1 and outputs and absolute value abs(S1) of said first input signal S1. Likewise, a further function block abs2 receives at its input the second input signal S2 and outputs at its output an absolute value abs(S2) of said second input signal S2.

An adder a2 adds the absolute values of the input signals S1, S2, whereby the sum signal $S_{BS}$ is obtained.

According to a particularly preferred embodiment, said sum signal $S_{BS}$ is forwarded to the predistortion branches 111, 112 of the digital predistortion device 100, whereby the particularly preferred predistortion algorithms, which depend on said sum signal $S_{BS}$, may be employed by those branches 111, 112. At an output of the branches 111, 112, respective digitally predistorted output signal $S1_{DPD}$, $S2_{DPD}$ are obtained.

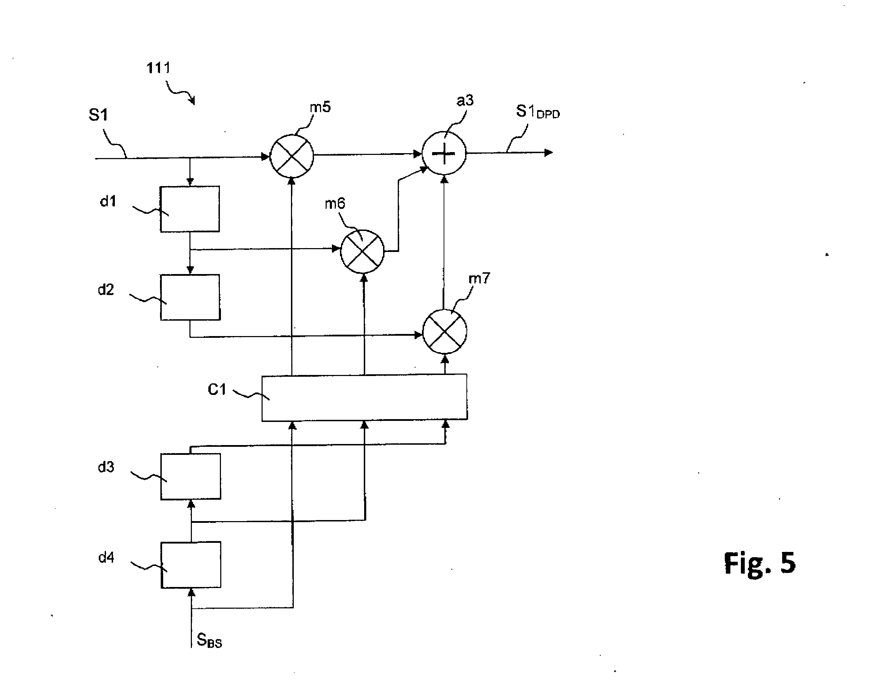

Fig. 5 depicts details of an exemplary structure of the first predistortion branch 111. An input signal S1 is received at an input section of the predistortion branch 111. The input signal S1 is forwarded to a delay block d1 which applies a predetermined delay to the input signal S1. A delayed output signal is forwarded from the first delay block d1 to a second delay block d2, which again delays the received input signal by a further predetermined delay.

The input signal S1, an output signal of the first delay block d1, and an output signal of the second delay block d2 are fed to respective multipliers m5, m6, m7 for a respective multiplication with digital predistortion coefficients provided by the digital predistortion coefficient section C1.

Output signals of the multipliers m5, m6, m7 are added by adder a3, whereby the digitally predistorted output signal $S1_{DPD}$ is obtained. As such, the digitally predistorted output signal $S1_{DPD}$ represents a linear combination of various delayed instances of the input signal S1 and the non-delayed input signal S1 which also depends on the predistortion coefficients delivered by block C1.

The structure according to Fig. 5 is only an exemplary embodiment of how a predistortion algorithm may be implemented within one of the predistortion branches 111, 112. As such, any other predistortion processing structures that enable digital predistortion may also be implemented within the predistortion branches 111, 112.

To account for the influence of both input signals S1, S2 on the nonlinearities added by the power amplifier 200 (Fig. 3), the predistortion branch 111 also receives the sum signal $S_{BS}$ as explained above with reference to Fig. 4.

The sum signal $S_{BS}$ is delayed by a first predetermined delay by the further delay block d4, and an output signal of said further delay block d4 is again delayed by delay block d3. The sum signal $S_{BS}$ and its delayed representations that have been obtained by the delay blocks d3, d4 are also forwarded to the DPD (Digital Predistortion) coefficient section C1 to enable a selection of the DPD coefficients delivered to the multipliers m5, m6, m7 depending on the sum signal $S_{BS}$.

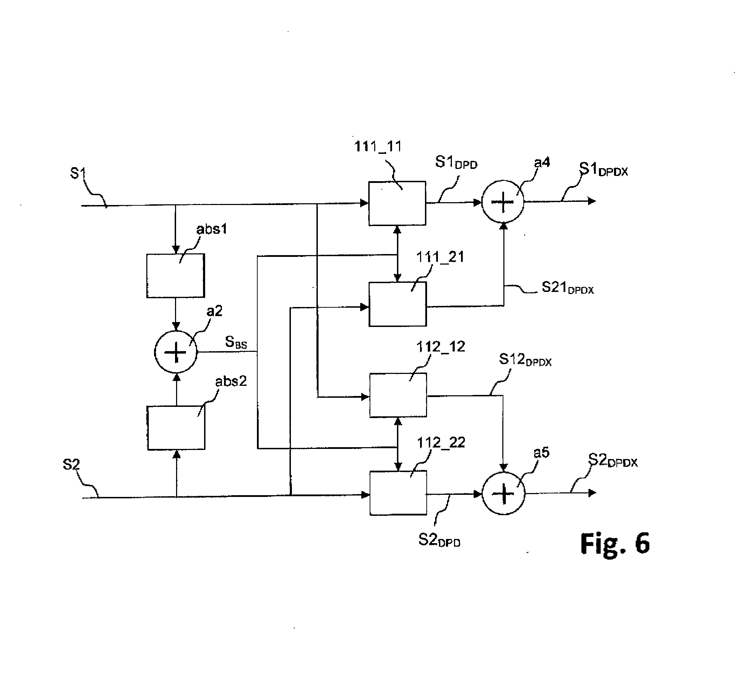

Fig. 6 depicts structural details of a digital predistortion device according to a further advantageous embodiment.

The digital predistortion device according to Fig. 6 comprises two predistortion branches 111_11, 112_22 which, as such, are similar to the predistortion branches 111, 112 already explained above with reference to Fig. 1, 5.

Consequently, at an output of the first predistortion branch 111_11, a digitally predistorted signal $S1_{DPD}$ is obtained. Likewise, at an output of said second predistortion branch 112_22, a second digitally predistorted output signal $S2_{DPD}$ is obtained.

Fig. 6 also depicts the signal processing components required for evaluating the sum signal $S_{BS}$, namely the absolute value blocks abs1, abs2, and the adder a2.

In addition to the first and second predistortion branches 111_11, 112_22, the digital predistortion structure according to Fig. 6 depicts crosstalk mitigation branches 111_21, 112_12.

As can be seen from Fig. 6, the first crosstalk mitigation branch 111_21 receives as an input signal the second input signal S2. Moreover, the first crosstalk mitigation branch 111_21 also receives the sum signal $S_{BS}$.

Depending on these input signals S2, $S_{BS}$, the first crosstalk mitigation branch 111_21 determines a first crosstalk mitigation signal $S21_{DPDX}$, which is added to the digitally predistorted output signal $S1_{DPD}$ by the adder a4, whereby the output signal $S1_{DPDX}$ is obtained.

The first crosstalk mitigation branch 111_21 advantageously accounts for possible crosstalk effects between the signals S1, S2 or further signals derived from S1, S2, which may result from a common signal processing of the output signals $S1_{DPDX}$, $S2_{DPDX}$ in the subsequent signal processing stages 210, 200 (Fig. 3). As such, since the output signal $S21_{DPDX}$ of the first crosstalk mitigation branch 111_21 is combined with the already predistorted input signal $S1_{DPD}$ by the adder a4, the first crosstalk mitigation branch 111_21 must not only consider crosstalk effects but also a predistortion. I.e., the first crosstalk mitigation branch 111_21 provides a kind of digitally predistorted crosstalk compensation signal $S21_{DPDX}$.

Likewise, the second crosstalk mitigation branch 112_12 receives the first input signal S1 and the sum signal $S_{BS}$ as input signals and determines an output signal $S12_{DPDX}$, which is added to the predistorted signal $S2_{DPD}$ by the adder a5, whereby the further output signal $S2_{DPDX}$ is obtained.

Due to the modification of the digitally predistorted output signals $S1_{DPD}$, $S2_{DPD}$ as received at an respective output of the digital predistortion branches 111_11, 112_22 by means of the crosstalk mitigation signals $S21_{DPDX}$, $S12_{DPDX}$, the effect of possible crosstalk on the output signals $S1_{DPDX}$, $S2_{DPDX}$ is reduced.

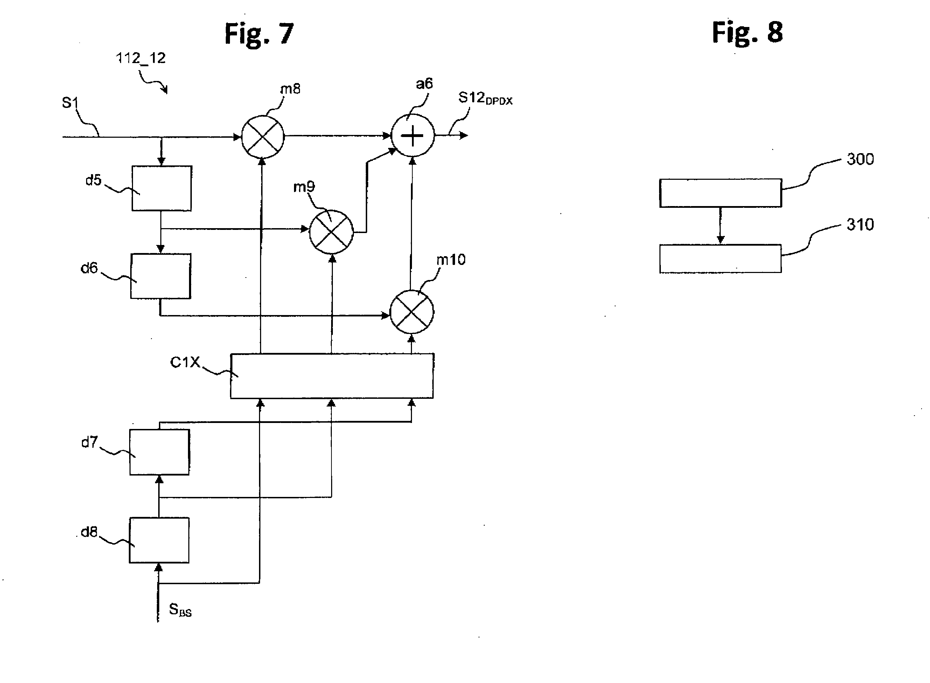

Fig. 7 depicts details of an exemplary structure of the second crosstalk mitigation branch 112_12 as employed by the digital predistortion structure explained above with reference to Fig. 6.

The second crosstalk mitigation branch 112_12 receives the input signal S1, $S_{BS}$. The input signals S1, $S_{BS}$ are delayed by delay blocks d5, d6, d7, d8 as can be seen from Fig. 7. The input signal S1 and its delayed representations obtained by the delay blocks d5, d6 are multiplied with digital predistortion and crosstalk mitigation coefficients obtained from the coefficient section C1X by means of the multipliers m8, m9, m10, and the output signals of the multipliers m8, m9, m10 are added by the adder a6 to obtain the output signal $S12_{DPDX}$, which is a digitally predistorted signal suitable to mitigate crosstalk effects the digitally predistorted signal $S2_{DPD}$ (Fig. 6) may suffer from.

The input signal $S_{BS}$ and its delayed representations as obtained at the outputs of the delay blocks d7, d8 are fed to the coefficient section C1x to control the selection of the coefficients employed for the multipliers m8, m9, m10.

Fig. 8 depicts a simplified flow chart of a method according to an embodiment.

In a first step 300, the digital predistortion device 100 according to the embodiments evaluates a sum $S_{BS}$ of absolute values of all input signals S1, S2 processed by the digital predistortion device 100.

In a subsequent step 310, each of said predistortion branches 111, 112 applies a predistortion to the input signals S1, S2 depending on said sum signal $S_{BS}$.

The sum signal $S_{BS}$, which represents the sum of absolute values of the input signals S1, can also be considered as a "beat signal" describing a temporal shape of the RF signal $S_{DPDRF}$ that is fed to the power amplifier 200 (Fig. 1), wherein the beat signal advantageously resembles an envelope signal in a strictly mathematically sense.

In contrast to the mathematically exact envelope signal, the beat signal $S_{BS}$ is only an approximation of the envelope of the RF signal $S_{DPDRF}$ which enables a particularly efficient determination by the digital predistortion device, namely by the signal processing components 115 as depicted by Fig. 4.

Unlike conventional predistortion approaches, the gain of the digital predistortion mechanism according to the embodiments inter alia depends on the beat signal $S_{BS}$ (i.e., the sum signal). In other words, the gain applied to each input signal S1, S2 in its respective predistortion branch 111, 112 is related to both input signals S1, S2 as defined by the beat signal $S_{BS}$. This yields the advantage of a particularly precise and efficient digital predistortion in cases where several signals S1, S2 (or their predistorted versions, respectively) are simultaneously processed by the amplifier 200.

Almost any known conventional DPD algorithms may be employed for defining the specific signal processing structure as exemplarily depicted by Fig. 5 for the first predistortion branch 111, as long as the inventive principle regarding the dependency of a predistortion function on a plurality of input signals S1, S2 is obeyed.

Generally, according to a particularly preferred embodiment, the predistortion functions f_DPD1, f_DPD2 to be implemented by the predistortion branches 111, 112 not only depend on the respective input signal S1, S2, but also on the beat signal.

I.e., the predistortion function f_DPD1 may be obtained as:

$$\mathtt{f\_DPD1 \; = \; f \; ( \; |S1| + |S2| \, , \; S1 ) ,}$$

and the predistortion function f_DPD2 may be obtained as:

$$\mathtt{f\_DPD2 \; = \; f \; ( \; |S1| + |S2| \, , \; S2 ) .}$$

In other words, according to the present embodiment, the predistortion within each branch 111, 112 is performed depending on the respective input signal S1, S2 as well as on the sum signal $S_{BS}$ = abs (S1) + abs (S2). The two functions f_DPD1 and f_DPD2 may be identical to each other.

Likewise, a mathematical description of the dependencies of the output signals of an embodiment of the crosstalk mitigation-enabled predistortion structure as depicted by Fig. 6 may be written as:

$$\mathtt{S1_{DPDX} \; = \; f11 \; ( \; |S1| + |S2| \, , \; S1 ) \; + \; f12 \; ( \; |S1| + |S2| \, , \; S2 ) ,}$$

wherein f11 represents a digital predistortion term as also employed by the predistortion branch 111 or 111_11, respectively, and wherein the further function f12 represents a crosstalk mitigation term employed to compensate crosstalk portions of the processed input signal S1.

Likewise, for the second input signal $S2_{DPDX}$, a mathematical representation may be chosen as:

$$S2_{DPDX} = f21\ (\ |S1| + |S2|,\ S1)\ +\ f22\ (\ |S1| + |S2|,\ S2),$$

wherein the function f22 represents a digital predistortion term as also employed by the second predistortion branch 112 or the branch 112_22, and wherein the further function f21 represents a crosstalk mitigation portion that accounts for crosstalk effects that might have been introduced by a common signal processing of the signals S1, S2, or signals derived thereof, in the components 210, 200 (Fig. 1).

The amplifier system 2000 as defined by the embodiments explained above advantageously provides a signal aggregation of the output signals $SL_{DPD}$, $S2_{DPD}$ in the analog domain, which is particularly advantageous since there is no requirement to process an aggregated signal having an increased bandwidth in the digital domain.

Rather, in the digital domain DD (Fig. 3), the digital baseband signals S1, S2 may be processed, and a processing bandwidth of the components 100, 111, 112 may e.g. be larger than the bandwidth of the input signals S1, S2 by a factor of 3 or 5, to account for higher signal frequencies that are introduced in the course of digital predistortion.

The power amplifier system 2000 as depicted by Fig. 3 advantageously enables to apply the concept of fragmented frequency bands with only one common power amplifier 200. If a frequency spacing $_\Delta f$ (Fig. 2) is high enough, for example in the hundreds of MHz region, it is assumed that the power amplifier 200 is not able to react to the envelope signal of the aggregated radio frequency signal $S_{DPDRF}$ any more. Thus, according to the embodiments, the sum signal $S_{BS}$ (beat signal) is provided for replacing the envelope signal. However, in comparison to the envelope signal in a strict mathematical sense, the bandwidth of the beat signal proposed by the embodiments only depends on the bandwidth of each single input signal S1, S2 and is particularly independent of the frequency spacing $_\Delta f$ which may - according to the principle of the fragmented frequency bands - assume comparatively high values of about some 10 GHz, depending on the target frequency of each input signal.

As already explained above, the evaluation of the beat signal $S_{BS}$ is comparatively simple and may e.g. be achieved by a signal processing structure 115 as depicted by Fig. 4.

According to a further preferred embodiment, a time delay of both predistortion paths 111 and 112 and the subsequent upconversion paths comprising the digital to analog converters DAC1, DAC2 and the multipliers m1, m2 as well as the adder a1 should be identical as seen from the signal input points at the input of the digital predistortion device 100. Otherwise, the beat signal $S_{BS}$ as provided by the embodiments does not correspond to the mathematically correct beat signal as present at an input of the power amplifier 200 due to delay effects.

To address this issue, delay components in the signal processing paths 111, 112 and the subsequent signal processing paths may be introduced to compensate any time delay mismatch of both processing paths.

Although the above explained embodiments focus on digital predistortion devices and methods explained in combination with two input signals S1, S2, the principle according to the embodiments may also be extended to simultaneously processing three or more input signals.

The digital predistortion approach presented by the embodiments advantageously enables to apply conventional power amplifier concepts for single band transmission systems to the principle of the fragmented frequency bands. The exemplary embodiments explained above cover most of the cases for simultaneous aggregation of high band plus high band and low band plus low band as discussed in 3GPP for fragmented carrier aggregation.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The functions of the various elements shown in the FIGS., including any functional blocks labelled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the FIGS. are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. Digital predistortion device (100) for applying a predistortion to a signal that is to be processed by a power amplifier (200), wherein said digital predistortion device (100) comprises at least two predistortion branches (111, 112), wherein each of said predistortion branches (111, 112) is configured to apply a predistortion to an input signal (S1, S2) of said predistortion branch (111, 112) according to a predistortion function (f_DPD1, f_DPD2) associated with said predistortion branch (111, 112), wherein a predistortion function (f_DPD1, f_DPD2) of at least one of said predistortion branches (111, 112) depends on the input signals (S1, S2) of at least two of said predistortion branches (111, 112).

2. Digital predistortion device (100) according to claim 1, wherein a predistortion function (f_DPD1, f_DPD2) of at least one of said predistortion branches (111, 112) depends on the input signals (S1, S2) of all of said predistortion branches (111, 112).

3. Digital predistortion device (100) according claim 1 or 2, wherein a predistortion function (f_DPD1, f_DPD2) of at least one of said predistortion branches (111, 112) depends on a sum of absolute values of said input signals (S1, S2).

4. Digital predistortion device (100) according to one of the preceding claims, wherein said digital predistortion device (100) comprises means (115) for evaluating a sum ($S_{BS}$) of absolute values of all input signals (S1, S2) processed by the digital predistortion device (100).

5. Digital predistortion device (100) according to one of the preceding claims, wherein said digital predistortion device (100) comprises at least one crosstalk mitigation branch (111_21) that is configured to modify an output ($S1_{DPD}$) of a first predistortion branch (111_11), which is associated with a first input signal (S1), depending on said first input signal (S1) and at least one further input signal (S2) processed by said digital predistortion device (100).

6. Digital predistortion device (100) according to one of the preceding claims, wherein said digital predistortion device (100) comprises a digital predistortion learning section (120) that is configured to receive at least one of: said input signals (S1, S2), output signals ($S1_{DPD}$, $S2_{DPD}$) of a predistortion branch (111, 112), feedback signals depending on said output signals ($S1_{DPD}$, $S2_{DPD}$), wherein said predistortion learning section (120) is further configured to modify at least one predistortion function (f_DPD1, f_DPD2) associated with at least one predistortion branch (111, 112).

7. Amplifier system (2000) comprising at least one digital predistortion device (100) according to one of the preceding claims, signal processing means (210) that are configured to transform a plurality of output signals ($S1_{DPD}$, $S2_{DPD}$) of said digital predistortion device (100) to a predistorted radio frequency, RF, signal ($S_{DPDRF}$), and a power amplifier (200) for amplifying said predistorted RF signal ($S_{DPDRF}$).

8. Amplifier system (2000) according to claim 7, wherein said signal processing means (210) comprise at least two upconversion paths (DAC1, LO1; DAC2, LO2), each of said upconversion paths being configured to transform an output signal ($S1_{DPD}$, $S2_{DPD}$) of said digital predistortion device (100) to a target frequency range associated with a respective center frequency (f1, f2) within said predistorted RF signal ($S_{DPDRF}$) -

9. Method of operating a digital predistortion device (100) for applying a predistortion to a signal that is to be processed by a power amplifier (200), wherein said digital predistortion device (100) comprises at least two predistortion branches (111, 112), wherein each of said predistortion branches (111, 112) applies (310) a predistortion to an input signal (S1, S2) of said predistortion branch (111, 112) according to a predistortion function (f_DPD1, f_DPD2) associated with said predistortion branch (111, 112), wherein a predistortion function (f_DPD1, f_DPD2) of at least one of said predistortion branches (111, 112) depends on the input signals (S1, S2) of at least two of said predistortion branches (111, 112).

10. Method according to claim 9, wherein a predistortion function (f_DPD1, f_DPD2) of at least one of said predistortion branches (111, 112) depends on the input signals (S1, S2) of all of said predistortion branches (111, 112).

11. Method according to one of the claims 9 to 10, wherein said digital predistortion device (100) evaluates (300) a sum $(S_{BS})$ of absolute values of all input signals (S1, S2) processed by the digital predistortion device (100), and wherein a predistortion function (f_DPD1, f_DPD2) of at least one of said predistortion branches (111, 112) depends on said sum $(S_{BS})$ of absolute values of said input signals (S1, S2).

12. Method according to one of the claims 9 to 11, wherein said digital predistortion device (100) comprises at least one crosstalk mitigation branch (111_21) that modifies an output $(SL_{DPD})$ of a first predistortion branch (111_11), which is associated with a first input signal (S1), depending on said first input signal (S1) and at least one further input signal (S2) processed by said digital predistortion device (100).

13. Method of operating an amplifier system (2000) according to one of the claims 7 to 8, wherein at least two input signals (S1, S2) are digitally predistorted by said digital predistortion device (100) to obtain predistorted output signals $(S1_{DPD}, S2_{DPD})$, wherein a plurality of said output signals $(S1_{DPD}, S2_{DPD})$ of said digital predistortion device (100) are transformed to a predistorted radio frequency, RF, signal $(S_{DPDRF})$ by said signal processing means (210), and wherein said predistorted RF signal $(S_{DPDRF})$ is amplified by said power amplifier (200).

14. Method according to claim 13, wherein at least two predistorted output signals (S1DPD, S2DPD) are upconverted from an input frequency range, preferably a baseband frequency range (BB), to an RF target frequency range associated with a respective center frequency (f1, f2) by multiplication with a corresponding local oscillator signal (LO1, L02).

## Fig. 1

## Fig. 2

Fig. 3

Fig. 4

Fig. 5

Fig. 6

Fig. 7

Fig. 8

EP 2 448 112 A1

Europäisches
Patentamt
European
Patent Office
Office européen
des brevets

# EUROPEAN SEARCH REPORT

**Application Number**

EP 10 29 0588

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 439 895 B1 (WIDDOWSON SCOTT [CA]) 21 October 2008 (2008-10-21) * column 6, line 49 - column 7, line 19; figure 8 * ----- | 1-14 | INV. H03F1/32 H03F3/189 H03F3/24 |
| X | US 2003/053552 A1 (HONGO NAOKI [JP] ET AL) 20 March 2003 (2003-03-20) * paragraphs [0037] - [0112], [0192] - [0197], [0215] - [0222], [0241] - [0244]; figures 7,10 * ----- | 1-14 | |
| A | US 6 313 703 B1 (WRIGHT ANDREW S [CA] ET AL) 6 November 2001 (2001-11-06) * column 17, lines 53-59 * ----- | 5,12 | |

| | | | TECHNICAL FIELDS SEARCHED (IPC) |
|---|---|---|---|
| | | | H03F |

The present search report has been drawn up for all claims

| Place of search | Date of completion of the search | Examiner |
|---|---|---|
| The Hague | 10 February 2011 | Goethals, Filip |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                             

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 29 0588

This annex lists the patent family members relating to the patent documents cited in the above-mentioned European search report.
The members are as contained in the European Patent Office EDP file on
The European Patent Office is in no way liable for these particulars which are merely given for the purpose of information.

10-02-2011

| Patent document cited in search report | | Publication date | Patent family member(s) | | Publication date |
|---|---|---|---|---|---|
| US 7439895 | B1 | 21-10-2008 | NONE | | |
| US 2003053552 | A1 | 20-03-2003 | CN | 1409497 A | 09-04-2003 |
| | | | EP | 1300941 A2 | 09-04-2003 |
| | | | JP | 3805221 B2 | 02-08-2006 |
| | | | JP | 2003092518 A | 28-03-2003 |
| US 6313703 | B1 | 06-11-2001 | NONE | | |

For more details about this annex : see Official Journal of the European Patent Office, No. 12/82